Europäisches Patentamt

European Patent Office

Office européen des brevets

(11) Veröffentlichungsnummer: **0 032 877**
**A1**

## (12) EUROPÄISCHE PATENTANMELDUNG

(21) Anmeldenummer: 81730004.9

(51) Int. Cl.³: **H 03 K 19/007**

(22) Anmeldetag: 10.01.81

(30) Priorität: 22.01.80 DE 3002482

(43) Veröffentlichungstag der Anmeldung: 29.07.81
Patentblatt 81/30

(84) Benannte Vertragsstaaten: AT BE CH DE FR GB IT LI LU NL

(71) Anmelder: Licentia Patent-Verwaltungs-GmbH,
Theodor-Stern-Kai 1, D-6000 Frankfurt/Main 70 (DE)

(72) Erfinder: Thöt, Reinhold, Dipl.-Ing., Emser Strasse 20,
D-1000 Berlin 44 (DE)

(74) Vertreter: Schickle, Gerhard, Dipl.-Ing. et al, Licentia
Patent-Verwaltungs-GmbH Theodor-Stern-Kai 1,
D-6000 Frankfurt/Main 70 (DE)

(54) Schaltungsanordnung zur logischen Verknüpfung wechselspannungsförmiger Eingangssignale.

(57) Schaltungsanordnung für einen fehlersicheren Logik-baustein. Diese Schaltungsanordnung sieht vor:

a) daß die Eingangssignale getrennten Eingangsübertragern zugeführt und in deren Sekundärkreisen durch eingeschaltete Gleichrichteranordnungen gleichgerichtet werden,

b) daß die gleichgerichteten Eingangssignale die einzelnen Steuerpotentiale für eine nachgeschaltete Transistor-Sperrschwingerschaltung mit Rückkopplungsübertrager bilden,

c) daß die Impulsspannung des Sperrschwingers über eine in den Sekundärkreis des Rückkopplungsübertragers eingeschaltete Verstärkerstufe dem Ausgang zugeführt wird.

Zur Erzeugung eines programmierten, abfallverzöger-ten Signals wird eine temperaturstabile Schaltungsanord-nung dadurch erreicht, daß ein an einem Eingang durch einen Taktgenerator (G) modifiziertes fail-safe UND-Glied und ein fail-safe ODER-Glied derart miteinander verbunden sind, daß der Eingang des UND-Gliedes, auf den das Eingangssignal gegeben wird, mit dem Eingang des ODER-Gliedes verbunden ist, daß der Ausgang (A) des ODER-Gliedes auf den mit dem Taktgenerator (G) beleg-ten Eingang des UND-Gliedes zurückgeführt ist, daß der Ausgang des UND-Gliedes auf eine Gleichrichterschaltung (GR) geführt ist, daß das UND-Glied wie das ODER-Glied mit je einem Kondensator (CT1, CT2) zur Aufrecht-erhaltung eines zeitlich begrenzten Steuerpotentials versehen sind und daß der Taktgenerator (G) eine KUJT-Kippschaltung enthält.

Im Falle des Auftretens von Bauteilefehlern soll die programmierbare Abfallverzögerungszeit der Schaltung nur verkürzt werden bzw. verschwinden.

1

## Schaltungsanordnung zur logischen Verknüpfung wechselspannungsförmiger Eingangssignale

Zusatz zu DBP 1 933 713, angemeldet: 28.6.1969

Die Erfindung bezieht sich auf eine Schaltungsanordnung nach dem Oberbegriff des Patentanspruchs.

Bei den bekannten Schaltungsanordnungen, z.B. UND-Glieder, ODER-Glieder usw., können am Ausgang bei Vorliegen eines Defektes, z.B. durch defekte Bauelemente, Leitungsunterbrechungen usw., unabhängig vom anliegenden Eingangssignal entweder dem Binärwert "O" (keine Spannung) oder dem Binärwert "L" (Spannung) entsprechende Signale auftreten. Hierdurch können falsche Steuersignale weitergeleitet werden, was bei Steuerschaltungen mit hohen Anforderungen an die Sicherheit, z.B. im Eisenbahnsignalwesen oder Kernreaktorbau, unzulässig ist.

Die bekannten Logikschaltungen weisen den Nachteil auf, daß im Störungsfall das Ausgangssignal unabhängig vom Eingangssignal nicht definiert ist.

Daher wurde im Hauptpatent 1 933 713 eine Schaltungsanordnung beschrieben, die im Fehlerfall jeweils zur sicheren Seite hin (keine Spannung am Ausgang) ausfällt.

Diese Schaltungsanordnung sieht die Kombination folgender Merkmale vor:

a) daß die Eingangssignale getrennten Eingangsübertragern zugeführt und in deren Sekundärkreisen durch eingeschaltete Gleichrichteranordnungen gleichgerichtet werden,

b) daß die gleichgerichteten Eingangssignale die einzelnen Steuerpotentiale für eine nachgeschaltete Transistor-Sperrschwingerschaltung mit Rückkopplungsübertrager bilden,

c) daß die Impulsspannung des Sperrschwingers über eine in den Sekundärkreis des Rückkopplungsübertragers eingeschaltete Verstärkerstufe dem Ausgang (A) zugeführt wird.

Bei der Zusammenstellung von kompletten Systemen aus den verschiedenen Schaltungsanordnungen ergibt sich häufig die Notwendigkeit, entweder Steuersignale über die systemspezifische Signallänge hinaus zu verlängern, z.B. um sicher zu stellen, daß angeschlossene Datenverarbeitungsanlagen genügend Zeit zur Abfrage des Signals erhalten, oder sehr kurze Signale auf die systemspezifische Signallänge zur Gewährleistung einer einwandfreien Verarbeitung zu bringen.

Es ist bereits eine Schaltungsanordnung vorgeschlagen worden, bei der ein an einem Eingang durch einen Taktgenerator modifiziertes fail-safe UND-Glied und ein fail-safe ODER-Glied derart miteinander verbunden sind, daß der Eingang des UND-Gliedes, auf den das Eingangssignal gegeben wird, mit dem Eingang des ODER-Gliedes verbunden ist, der Ausgang des ODER-Gliedes auf den mit dem Taktgenerator belegten Eingang des UND-Gliedes rückgeführt ist, der Ausgang des UND-Gliedes auf den 2. Eingang des ODER-Gliedes geführt ist und das UND-Glied wie das ODER-Glied mit je einem Kondensator zur Aufrechterhaltung eines zeitlich begrenzten Steuerpotentials versehen sind (P 27 59 266). Diese Schaltung ist jedoch nicht genug temperaturstabil.

Die Aufgabe besteht daher darin, eine temperaturstabile fail-safe Schaltungsanordnung anzugeben, bei der ein programmiertes, abfallverzögertes Signal erzeugt wird. Die Schaltung ist so auszulegen, daß sich im Falle von Bauteilefehlern die programmierbare Abfallverzögerungszeit nur verkürzt bzw. verschwindet. Die Aufgabe wird nach der Erfindung durch die im Patentanspruch angegebenen Maßnahmen gelöst.

Die Erfindung wird im folgenden anhand von Zeichnungen näher erläutert.

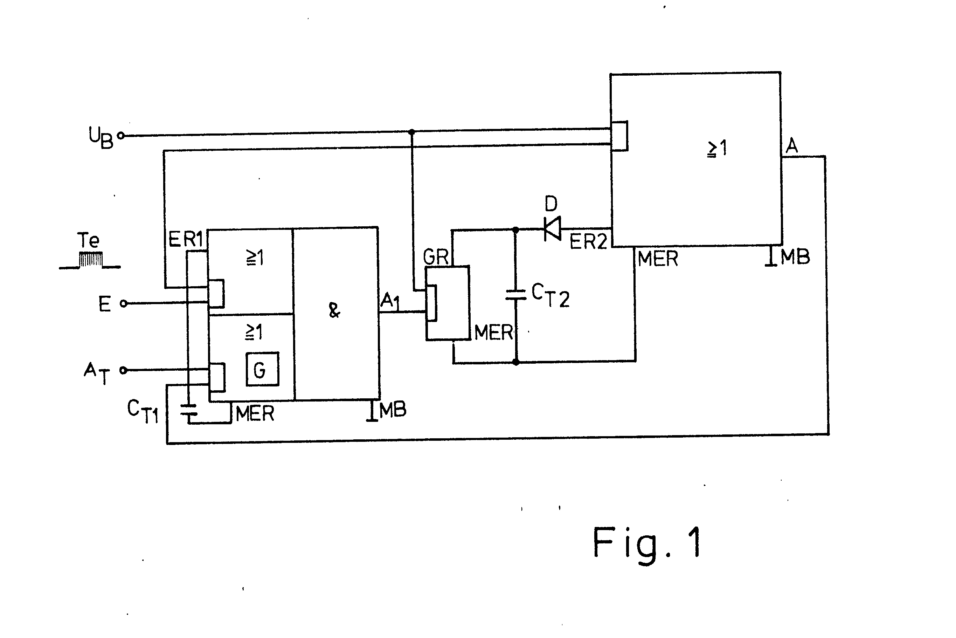

In Fig. 1 ist ein Blockschaltbild der Schaltungsanordnung nach der Erfindung dargestellt. Sie besteht aus einem fail-safe ODER-Glied mit Eingangsübertrager und Er- weiterungseingängen. Zwischen einem statischen Erweite- rungseingang ER und einem Masseerweiterungseingang MER liegt ein Kondensator $C_{T2}$, außerdem ist in der Schaltungsanordnung ein fail-safe UND-Glied enthalten mit Eingangsübertragern. Zur Verkleinerung der Einschaltverzögerung ist eine Diode D eingefügt.

Zwischen einem statischen Erweiterungseingang ER und einem Masseerweiterungseingang MER liegt hier ebenfalls ein Kondensator $C_{T1}$. Das fail-safe UND-Glied ist an einem seiner Eingänge modifiziert durch Einfügen eines zusätzlichen Taktgenerators G. Sein Ausgang $A_1$ ist mit einer Gleichrichterschaltung GR verbunden. Auf die Gleichrichterschaltung und auf einen Eingang des fail-safe ODER-Gliedes wird die Betriebsspannung $U_B$ gegeben. Der Ausgang des fail-safe ODER-Gliedes ist rückgeführt auf den Eingang des fail-safe UND-Gliedes, der durch den Taktgenerator G modifiziert ist.

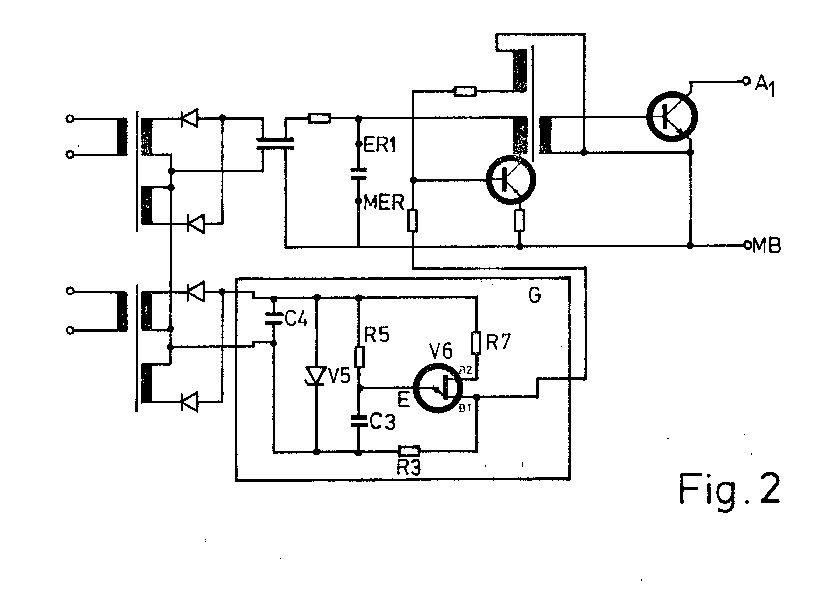

Das fail-safe UND-Glied, das durch den Taktgenerator modifiziert ist, wird in Fig. 2 genauer dargestellt. Dem bekannten fail-safe UND-Glied mit den Eingangsübertragern und den Ausgangsübertragern und der Sperrschwingerschaltung ist ein Taktgenerator mit einem KUJT-Kippschaltkreis (KUJT = Komplementär-Unijunktidtransistor) hinzugefügt.

Der Generator erzeugt kurze, negative Auftastimpulse für die Schwingstufe, die im zeitlichen Abstand $T_R \geqslant t_L$ wiederkehren. $t_L$ ist die Nachladezeitdauer, während der die Kapazität $C_{T2}$ nachgeladen wird; $T_R$ ist die Wiederholungsrate.

Der Kollektoreingang des fail-safe UND-Gliedes und ein Eingang des fail-safe ODER-Gliedes werden von einem gemeinsamen Eingangsimpuls $T_e$ gesteuert. Dabei wird über Gleichrichterschaltungen ein Kondensator $C_{T1}$ und ein Kondensator $C_{T2}$ aufgeladen. Die Energie des Kondensators $C_{T2}$ setzt nun den Oszillator des fail-safe ODER-Gliedes in Funktion, dessen Ausgang mit nachfolgender Gleichrichtung den Basisteil des fail-safe UND-Gliedes mit Energie

versorgt. Diese dient zur Versorgung des Taktgenerators G, der aus dem Komplementär-Unijunktiontransistor mit nachfolgender Verstärkerstufe gebildet wird. Der Taktgenerator hat die Aufgabe, impulsweise die Schwingbedingung für den internen Oszillator des fail-safe UND-Gliedes herzustellen. Diese Schwingung wird in einer Transistorstufe verstärkt und dem anderen Eingang des fail-safe ODER-Gliedes zugeführt.

Der Kondensator $C_{T2}$ bewirkt direkt eine Abfallverzögerung des Ausgangssignals des fail-safe ODER-Gliedes. Diese Abfallverzögerung soll nun verlängert werden. Dies geschieht durch impulsweises Nachladen des Kondensators $C_{T2}$. Die Energie dazu wird dem Kondensator $C_{T1}$ entnommen.

Die Nachladeperiode ist dann abgeschlossen, wenn die Spannung des Kondensators $C_{T1}$ unter einen Schwellwert entladen ist. Der Rückkopplungsweg zur Versorgung des Basiskreises des fail-safe UND-Gliedes bricht nach Entladung des Kondensators $C_{T2}$ schlagartig zusammen. Der Vorgang kann dann nur durch einen neuen Eingangsimpuls $T_e$ gestartet werden.

Der Vorteil der Schaltungsanordnung nach der Erfindung besteht darin, daß die Abfall-Verzögerungseigenschaften von Verknüpfungsgliedern des Systems LOGISAFE ausgenutzt werden. Der Aufbau ist niederohmig und die Wiederholgenauigkeit ist größer sowie die Fremdspannungsstörung ist wesentlich geringer als bei den bekannten Schaltungen. Die Temperaturstabilität ist groß und es sind mit kleineren Kondensatoren längere Verzögerungszeiten zu erreichen.

- - - - - -

Patentanspruch

Schaltungsanordnung zur logischen Verknüpfung wechselspannungsförmiger Eingangssignale zu einem wechselspannungsförmigen Ausgangssignal, bei der die Kombination folgender Merkmale vorliegt:

a) daß die Eingangssignale getrennten Eingangsübertragern
zugeführt und in deren Sekundärkreisen durch eingeschaltete Gleichrichteranordnungen gleichgerichtet
werden,

b) daß die gleichgerichteten Eingangssignale die einzelnen Steuerpotentiale für eine nachgeschaltete Transistor-Sperrschwingerschaltung mit Rückkopplungsübertragern bilden,

c) daß die Impulsspannung des Sperrschwingers über eine
in den Sekundärkreis des Rückkopplungsübertragers
eingeschaltete Verstärkerstufe dem Ausgang zugeführt
wird, nach Patent 1 933 713, dadurch gekennzeichnet, daß ein an einem Eingang durch einen Taktgenerator modifiziertes fail-safe UND-Glied und ein fail-safe ODER-Glied derart miteinander verbunden sind, daß der Eingang des UND-Gliedes, auf den das Eingangssignal gegeben wird, mit dem Eingang des ODER-Gliedes verbunden ist, daß der Ausgang des ODER-Gliedes auf den mit dem Taktgenerator belegten Eingang des UND-Gliedes rückgeführt ist, daß der Ausgang des UND-Gliedes auf eine Gleichrichterschaltung geführt ist, daß das UND-Glied wie das ODER-Glied mit je einem Kondensator zur Aufrechterhaltung eines zeitlich begrenzten Steuerpotentials versehen sind und daß der Taktgenerator (G) eine KUJT-Kippschaltung enthält.

- - - - -

0032877

Fig. 1

Fig. 2

0032877

Nummer der Anmeldung

EP

**EUROPÄISCHER RECHERCHENBERICHT**

Europäisches
Patentamt

| EINSCHLÄGIGE DOKUMENTE | | | KLASSIFIKATION DER ANMELDUNG (int. Cl.³) |
|---|---|---|---|
| Kategorie | Kennzeichnung des Dokuments mit Angabe, soweit erforderlich, der maßgeblichen Teile | betrifft Anspruch | |
| | DE - A1 - 2 759 260 (LICENTIA PATENT-VERWALTUNGS-GMBH) <br><br> * Patentanspruch; Fig. 1, 2 * <br><br> -- <br><br> DE - A1 - 2 817 680 (LICENTIA PATENT-VERWALTUNGS-GMBH) <br><br> * Patentanspruch; Seite 6, Zeilen 19 bis 22; Fig. 1 * <br><br> -- | Anspruch <br><br><br><br><br><br> Anspruch | H 03 K 19/007 |
| A | DE - A1 - 2 538 977 (LICENTIA PATENT-VERWALTUNGS-GMBH) <br><br> -- | | RECHERCHIERTE SACHGEBIETE (Int. Cl.³) |
| A | DE - A - 1 933 713 (LICENTIA PATENT-VERWALTUNGS GMBH) <br><br> ---- | | H 03 K 19/007 |

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patent-familie, übereinstimmendes Dokument

| X | Der vorliegende Recherchenbericht wurde für alle Patentansprüche erstellt. |
|---|---|

| Recherchenort | Abschlußdatum der Recherche | Prüfer |
|---|---|---|
| Berlin | 09-04-1981 | ARENDT |

EPA form 1503.1  06.78